Europäisches Patentamt

European Patent Office

Office européen des brevets

(19)

(11) Veröffentlichungsnummer: **0 053 742**
**A1**

(12) # EUROPÄISCHE PATENTANMELDUNG

(21) Anmeldenummer: **81109732.8**

(22) Anmeldetag: **17.11.81**

(51) Int. Cl.³: **H 01 L 31/12**
**H 04 B 9/00**

(30) Priorität: **06.12.80 DE 3046140**

(43) Veröffentlichungstag der Anmeldung:
**16.06.82 Patentblatt 82/24**

(84) Benannte Vertragsstaaten:
**CH DE FR GB IT LI NL SE**

(71) Anmelder: **Licentia Patent-Verwaltungs-GmbH**
**Theodor-Stern-Kai 1**
**D-6000 Frankfurt/Main 70(DE)**

(72) Erfinder: **Petermann, Klaus, Dr.-Ing.**
**Stachelbeerweg 34**
**D-7900 Ulm(DE)**

(72) Erfinder: **Schlosser, Ewald, Dipl.-Phys.**
**Dorfstrasse 9**
**D-7913 Senden(DE)**

(74) Vertreter: **Schickla, Gerhard, Dipl.-Ing. et al,**
**Licentia Patent-Verwaltungs-GmbH Theodor-Stern-Kai 1**
**D-6000 Frankfurt/Main 70(DE)**

(54) **Signalübertragungsverfahren, ein Halbleiter-Bauelement sowie ein elektro-optisches Bauelement zur Durchführung des Verfahrens.**

(57) Die Erfindung betrifft insbesondere ein Lichtleitfaser Signalübertra-gungsverfahren mit mindestens einem elektro-optischen Halbleiter-Bauelement (20), in dem mindestens ein Sender (21) (Hetero-Lumineszenzdiode) und mindestens ein Empfänger (22) (Photodetektor) derart angeordnet sind (hintereinander), daß optische Weichen (sonst üblich bei einem Duplex-System) entfallen.

FIG.2

EP 0 053 742 A1

Licentia Patent-Verwaltungs-GmbH
Theodor-Stern-Kai 1

D-6000 Frankfurt (Main) 70

NE2-UL/Ja/rß
UL 80/102

Beschreibung

Signalübertragungsverfahren, ein Halbleiter-Bauelement
sowie ein elektro-optisches Bauelement zur Durchführung
des Verfahrens

Die Erfindung betrifft ein Signalübertragungsverfahren, ein
Halbleiter-Bauelement sowie ein elektro-optisches Bauelement
zur Durchführung des Verfahrens nach den Oberbegriffen der
Patentansprüche 1, 8 und 23.

Die Erfindung betrifft insbesondere ein sogenanntes Duplex-
Verfahren, das in der optischen Nachrichtentechnik angewandt
wird.

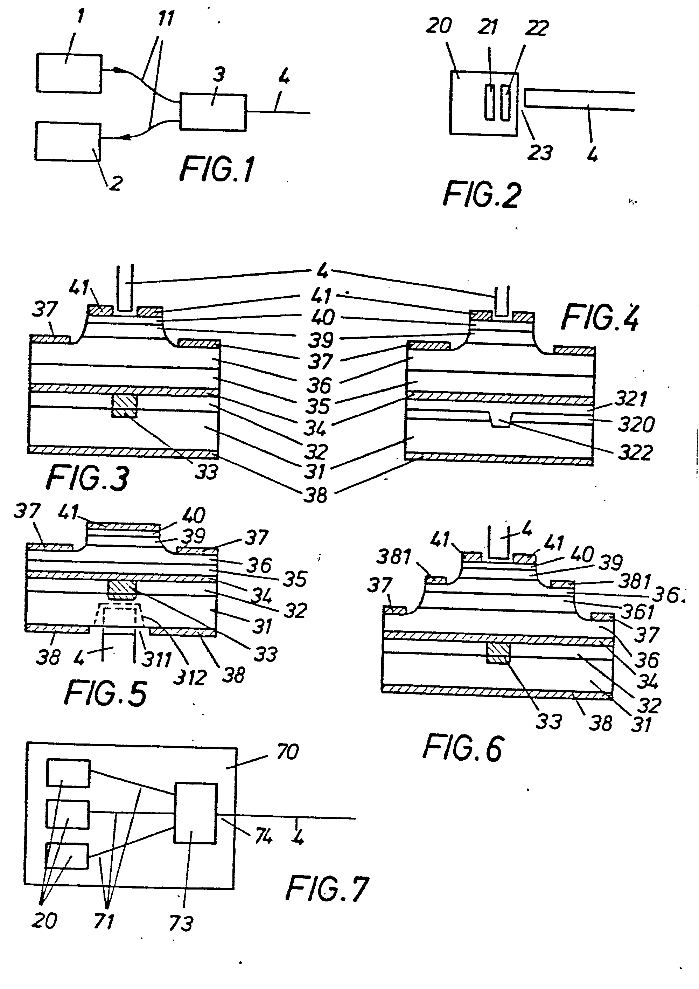

Bei einem derartigen Verfahren wird Information in entgegengesetzten Richtungen gleichzeitig über einen Lichtweg, beispielsweise eine Lichtleitfaser, übertragen. FIG. 1 zeigt

...

eine schematische Darstellung eines derartigen Verfahrens. Das von einem elektro-optischen Sender 1, z.B. einer Lumineszenzdiode ausgesandte Licht wird über einen ersten Lichtweg 11 einem optischen Verteiler 3 zugeführt und in einem zweiten Lichtweg 4 eingekoppelt, z.B. eine Lichtleitfaser, der die Information zu einer nicht dargestellten Empfangs- und Sendestation überträgt. Von dieser Station ausgesandtes Licht gelangt über den Lichtweg 4, den Verteiler 3, einen weiteren ersten Lichtweg 11 zu einem Empfänger 2, beispielsweise einer Photodiode, wird dort in ein elektrisches Signal umgewandelt und in bekannter Weise weiterverarbeitet.

Ein derartiges Signalübertragungsverfahren hat den Nachteil, daß die durch Sender 1, Empfänger 2, erste Lichtwege 11 und den Verteiler 3 gebildete Anordnung aufwendig und schwierig zu justieren ist, insbesondere, wenn die Lichtwege als Lichtleitfasern ausgeführt werden.

Der Erfindung liegt daher die Aufgabe zugrunde, ein Signalübertragungsverfahren, ein Halbleiter-Bauelement sowie ein elektro-optisches Bauelement anzugeben, wodurch die genannte Anordnung wesentlich vereinfacht wird. Diese Aufgabe wird erfindungsgemäß durch die in den kennzeichnenden Teilen der Ansprüche 1, 8 und 23 angegebenen Merkmale gelöst.

Weitere Ausbildungen und Ausgestaltungen sind in den Unteransprüchen zusammengestellt.

Ein Vorteil der Erfindung besteht darin, daß bei dem Signalübertragungsverfahren ein Halbleiter-Bauelement verwendet wird, das einen elektro-optischen Sender und einen opto-elektrischen Empfänger enthält derart, daß das Halbleiter-Bauele

...

ment unmittelbar an einen Lichtweg, insbesondere eine Lichtleitfaser, ankoppelbar ist, so daß erste Lichtwege und ein
optischer Verteiler entfallen.

Die Erfindung wird im folgenden anhand von schematischen
Zeichnungen näher erläutert. Es zeigen:

FIG. 2   eine schematische Darstellung des erfindungsgemäßen
          Signalübertragungsverfahrens,

FIG. 3   Ausführungsbeispiele des erfindungsgemäßen Halblei-
bis 6    ter-Bauelementes

FIG. 7   ein Ausführungsbeispiel des erfindungsgemäßen elektro-
          optischen Bauelementes.

FIG. 2 zeigt ein Halbleiter-Bauelement 20, das in integrierter Bauweise einen elektro-optischen Sender 21 und einen opto-
elektrischen Empfänger 22 enthält. Das Halbleiter-Bauelement
20 wird über eine optische Koppelstelle 23 mit einem Lichtweg
4, beispielsweise eine Lichtleitfaser, verbunden, der zu einer nicht dargestellten weiteren Sende- und/oder Empfangsstation, beispielsweise ebenfalls ein Halbleiter-Bauelement 20,
führt. Sender 21 und Empfänger 22 werden aus einer hintereinanderliegenden Schichtenfolge aus Halbleitermaterial, beispielsweise dotiertes und undotiertes GaIn AsP gebildet derart,
daß Licht senkrecht zu den Schichtebenen ausgesandt und/oder
empfangen wird, und daß beispielsweise jeweils zwei Schichten
einen pn-Übergang für Sende- und Empfangsdiode bilden. Bei
dem in FIG. 2 dargestelltem Beispiel liegt der Empfänger 22
zwischen dem Sender 21 und dem Lichtweg 4. Vom Sender 21 ausgesandtes Licht wird nur dann in den Lichtweg 4 eingekoppelt,

...

0053742

UL 80/102

wenn es nicht im Empfänger 22 absorbiert wird. Dies wird erfindungsgemäß dadurch erreicht, daß ausgesandtes und/oder empfangenes Licht unterschiedliche Wellenlängen besitzen, d.h. die den Sender 21 bzw. den Empfänger 22 bildenden Halbleiterschichten haben unterschiedliche Energie-Bandabstände. In dem dargestellten Beispiel hat der Sender 21 daher einen kleineren optisch wirksamen Bandabstand als der Empfänger 22, das ausgesandte Licht besitzt eine größere Wellenlänge als das empfangene. Bei der nicht dargestellten, an den Lichtweg 4 angekoppelten, Sende- und/oder Empfangsstation werden alternative Bedingungen benötigt, d.h. ausgesandtes Licht hat eine kleinere Wellenlänge als das empfangene. Derartige Bedingungen werden in einem Halbleiter-Bauelement ermöglicht., bei dem zwar die Anordnung von Sender und Empfänger vertauscht wird, gegenüber der in FIG. 2 dargestellten, die Anordnung der optische wirksamen Bandabstände bleibt jedoch erhalten, d.h. das dem Lichtweg 4 nächstgelegene Element, Sender oder Empfänger, hat den höheren Bandabstand. Mit derartigen Halbleiter-Bauelementen wird ein bidirektionales optisches Signalübertragungsverfahren, ein sogenanntes Duplex-Verfahren, ermöglicht, bei dem erste Lichtwege 11 und optische Verteiler 3, z.B. optische Weichen, überflüssig werden, da das Halbleiter-Bauelement 20 über eine, für Sender 21 und Empfänger 22, gemeinsame Koppelstelle 23 an den Lichtweg 4 angekoppelt wird. Da ausgesandtes bzw. empfangenes Licht unterschiedliche Wellenlängen besitzen, wird ein störendes Übersprechen der übermittelten Information weitgehend vermieden.

Die FIG. 3 bis 6 zeigen Ausführungsbeispiele des Halbleiter-Bauelementes 20. Bei dem Halbleiter-Bauelement gemäß FIG. 3 ist auf einem Substrat 31 eine Halbleiterschicht 32 aufgebracht, dessen Dotierung von der des Substrates 31 verschieden ist und in der, z.B. durch Diffusion, ein Strompfad 33 des Leitfähigkeitstyps des Substrats 31 bis zur Schicht 34 geschaffen ist. Der Dotierungstyp p oder n der Schichten

...

35, 36 ist entgegengesetzt der Dotierung des Substrates 31, so daß sich in oder an der Schicht 34 ein pn-Übergang bildet. Die Schicht 34 besteht aus einem Halbleitermaterial mit direktem Übergang zwischen Leitungs- und Valenzband, so daß beim Anlegen einer elektrischen Spannung zwischen den Kontakten 37 und 38 (Polung in Flußrichtung) in der Schicht 34 eine Lichtemission erzeugt wird. Die Schichten 35, 36, 39, 40 haben einen größeren Bandabstand als die Schicht 34, so daß die Lichtemission der Schicht 34 mit nur geringen Verlusten zum Lichtweg 4 gelangt. Die Schicht 39 ist möglichst schwach oder gar nicht dotiert, wohingegen der Leitfähigkeitstyp der Schicht 40 entgegengesetzt ist zum Leitfähigkeitstyp der Schichten 35, 36. Zwischen den Kontakten 41 und 37 ist ebenfalls ein pn-Übergang an oder in der Schicht 39 gebildet, der durch Anlegen einer elektrischen Spannung zwischen den Kontakten 41 und 37 in Sperrichtung betrieben wird und so als Empfänger (Photodiode) wirkt. Die Dotierung der Schicht 39 ist gering gewählt, um die Sperrschichtkapazität gering zu halten. Dem gleichen Zweck dient die in FIG. 3 dargestellte sogenannte Mesa-Ätzung. Der Bandabstand der Schicht 39 ist größer als der Bandabstand der Schicht 34, so daß bei dem in FIG. 3 dargestellten Halbleiterbauelement das ausgesandte Licht eine größere Wellenlänge hat als das empfangene.

Als Beispiel sei die Dimensionierung für ein erfindungsgemäßes Bauelement angegeben, das bei der Wellenlänge $\lambda_2$ = 1,3 $\mu$m sendet:

...

| Schicht | Halbleiter-material | Dotierung Typ | Konzentration | Schicht-dicke |
|---------|---------------------|---------------|---------------|---------------|
| 31 | InP-Substrat | p | $p \gtrsim 10^{18} cm^{-3}$ | |
| 32 | InP | n | $n \approx 10^{18} cm^{-3}$ | $4 \mu m$ |
| 34 | $Ga_{1-x} In_x As_{1-y} P_y$ | n oder p | $x = 0,72, (1-x)/(1-y) = 0,47$ | $1 \mu m$ |
| 35 | entfällt | | | |
| 36 | InP | n | $n \gtrsim 10^{18} cm^{-3}$ | $5-10 \mu m$ |
| 39 | InP | n oder p schwach dotiert | | $1...2 \mu m$ |

Die Schicht 40 wird realisiert durch flache p-Diffusion in die Schicht 39. Der Mesa hat einen Durchmesser von ungefähr 100 bis 200 $\mu m$, und der Durchmesser des p-diffundierten Bereiches 33 liegt bei 30 bis 50 $\mu m$.

Zur Herstellung dieses Elements wird auf das InP-Substrat 31 die Schicht 32 epitaktisch aufgewachsen. Dann wird der Epitaxie-Prozeß unterbrochen und mit einer maskierten Zn-Diffusion der Strompfad 33 geschaffen. Anschließend werden die Schichten 34, 35, 36, 39 epitaktisch aufgewachsen. Eventuell wird zwischen der Schicht 32 und 34 noch eine Zusatzschicht aufgebracht. Es folgt dann eine flache p-Diffusion, so daß die Schicht 40 entsteht. Anschließend folgt die Mesa-Ätzung sowie ein eventuelles Abschleifen des Substrates 31 und schließlich werden noch Kontakte 37, 38 und 41 aufgebracht. Ein eventuelles Abschleifen des Substrates 31 verfolgt den Zweck, den Ab-

...

stand zwischen der lichtemittierenden Schicht 34 und dem Kontakt 38 zu verringern, so daß dann thermische Eigenschaften verbessert werden, wenn das Element am Kontakt 38 mit einer Wärmesenke verbunden wird.

Statt einer Diffusion kann eine Formung des Substrates 33 zur Schicht 34, wie in FIG. 4 dargestellt, auch dadurch erfolgen, daß die Schicht 32 in Schichten 320, 321 aufgeteilt wird. Die Schicht 320 hat dabei den entgegengesetzten Leitfähigkeitstyp wie das Substrat 31 und wird zunächst allein aufgewachsen. Es wird dann ein Loch geätzt und die Schicht 321 aufgewachsen, deren Leitfähigkeitstyp dem des Substrates 31 entspricht. Es entsteht dadurch ein kreisförmiger Leitfähigkeitspfad 322 ähnlich wie in FIG. 3. Auch bei dem Halbleiter-Bauelement gemäß FIG. 3 ist es möglich, zwischen Schicht 32 und Schicht 34 eine weitere Schicht 321, gemäß FIG. 4, vorzusehen. Dadurch wird ein störender elektrischer Stromfluß außerhalb des Strompfades 33 weiter verringert.

Bei den gemäß FIG. 3 und FIG. 4 beschriebenen Halbleiter-Bauelementen hat das ausgesandte Licht eine größere Wellenlänge als das empfangene. Mit einer leichten Abwandlung des gemäß FIG. 3 beschriebenen Halbleiter-Bauelementes läßt sich gemäß FIG. 5 ein Halbleiter-Bauelement angeben, bei dem das ausgesandte Licht eine kleinere Wellenlänge hat als das empfangene.

Die lichtemittierende Zone befindet sich wieder in der Schicht 34, während die Schicht 39 das ankommende Licht der größeren Wellenlänge detektiert. Für eine gute Detektion darf lediglich die Schicht 39 Licht der größeren Wellenlänge absorbieren, während die Schichten 31, 32, 33, 34, 35, 36 für diese Wellenlänge durchlässig sein müssen. Insbesondere ist der Bandabstand der Schicht 34 größer als der der Schicht 39, während der Bandabstand der Schicht 36 zwischen dem der Schicht 34 und

. . .

dem der Schicht 39 liegt. Damit hat die Schicht 36 die Aufgabe, von der Schicht 34 ausgesandtes Licht mit der kleineren Wellenlänge, zu absorbieren, bevor es zur Schicht 39 gelangt und auf derartige Weise ein Übersprechen verursacht. Weiterhin ist es möglich, statt der Schicht 36 eine Schichtenfolge vorzusehen, die die ausgesandte kleinere Wellenlänge selektiv reflektiert. Die Schichten 32 und 35 weisen einen höheren Bandabstand auf als die Schicht 34, wodurch eine vorteilhafte Eigenschaften besitzende Hetero-Lumineszenzdiode als Sender entsteht.

Entsprechend FIG. 3, ist mit den Kontakten 37 und 38 die Lumineszenzdiode als Sender und mit den Kontakten 41 und 37 die Photodiode als Empfänger ansteuerbar. Der Lichtweg 4, insbesondere eine Lichtleitfaser, ist an einen Bereich 311 des Substrates 31 ankoppelbar, der nicht von dem Kontakt 38 bedeckt wird.

Als Beispiel wird die Dimensionierung für ein Halbleiter-Bauelement beschrieben, das Licht von 1.1 $\mu$m Wellenlänge aussendet und Licht von 1.3 $\mu$m Wellenlänge empfängt:

| Schicht | Halbleitermaterial | Dotierung Typ | / Konzentration | Schichtdicke |
|---|---|---|---|---|
| 31: | InP-Substrat | p | $p \gtrsim 10^{18}$ cm$^{-3}$ | |
| 32: | InP | n | $n \approx 10^{18}$ cm$^{-3}$ | 4 $\mu$m |
| 34: | $Ga_{1-x_3} In_{x_3} As_{1-y_3} P_{y_3}$ | n oder p | $x_3 = 0.87(1-x_3)/$ $(1-y_3) = 0,47$ | 1 $\mu$m |

. . .

| Schicht | Halbleitermaterial | Dotierung Typ | /Konzentration | Schicht- dicke |
|---|---|---|---|---|
| 35: | InP | n | $n \approx 10^{18} cm^{-3}$ | $2 \mu m$ |
| 36: | $Ga_{1-x_4} In_{x_4} As_{1-y_4} P_{y_4}$ | n | $n \approx 10^{18} cm^{-3}$ $x_4 = 0.76$ $(1-x_4)/1-y_4)=0.47$ | $10 \mu m$ |
| 39: | $Ga_{1-x_5} In_{x_5} As_{1-y_5} P_{y_5}$ | n od. p schwach dotiert | $x_5 < 0,72$ $(1-x_5)/(1-y_5)=0,47$ | $1 - 2 \mu m$ |

Die Schicht 40 wird durch flache p-Diffusion in die Schicht 39 erzeugt.

Die Herstellung erfolgt wie im vorhergehenden Beispiel. Eine bessere Ankopplung des Lichtweges 4 wird erreicht wenn eine Vertiefung 312 in das Substrat 31 geätzt wird (gestrichelt dargestellt in FIG. 5), so daß der Lichtweg 4 näher an der lichemittierenden Zone in der Schicht 34 liegt.

Nachteilig an den Halbleiter-Bauelementen gemäß FIG. 3 und FIG. 5 ist, daß die lichtemittierende Schicht 34 weit (einige $10 \mu m$) vom Kontakt 38, und damit von einer möglichen mit diesem verbundenen Wärmesenke entfernt ist, so daß die Wärmesenke möglicherweise nicht optimal ist.

Deshalb ist es erfindungsgemäß möglich, die Schicht 35 durch ein Substrat zu ersetzen, auf das beidseitig eine Schichtenfolge entsprechend den FIG. 3 und 5 aufgewachsen wird. Die

...

der Schicht 31 entsprechende ist dann dünn (einige /um) ausgebildet, und der Strompfad 33 ist durch Diffusion von der
Oberfläche der Schicht 31 her entstanden.

Nachteilig an den vorgenannten Halbleiter-Bauelementen ist,
daß ein gemeinsamer Kontakt 38 für Photodiode (Empfänger)
und lichtemittierender Diode (Sender) besteht, so daß ein
Übersprechen, insbesondere bei hohen Frequenzen, unvermeidbar ist.

In einer weiteren Ausbildung der Erfindung wird dieser Nachteil gemäß FIG. 6 dadurch beseitigt, daß zwischen die Schichten 36 und 39 noch mindestens eine weitere Schicht 361, 362
eingefügt ist, um Kontakte 381 und 38 voneinander zu isolieren. Die Photodiode (Empfänger) wird zwischen den Kontakten
41 und 381 angesteuert, während die lichtemittierende Diode
(Sender) zwischen den Kontakten 37 und 38 betrieben wird.
Die Schicht 35 ist in dem Halbleiter-Bauelement gemäß FIG.6
weggelassen, sie kann aber eingefügt werden, zum Beispiel
als Substrat, auf das beidseitig, wie beschrieben, verschiedene Schichten aufgebracht werden. Entsprechend FIG. 3 hat
bei dem Halbleiter-Bauelement gemäß FIG. 6 das ausgesandte
Licht eine größere Wellenlänge als das empfangene, die Bandabstände der Schichten 361, 362 sind so gewählt, daß sie für
die größere Wellenlänge transparent sind. Um die elektrisch
isolierende Wirkung zwischen den Kontakten 381, 38 sicherzustellen, muß wenigstens eine der Schichten 361, 362 einen
Leitfähigkeitstyp besitzen, der verschieden ist vom Leitfähigkeitstyp der Schicht 36. Hat beispielsweise die Schicht 362
den gleichen Leitfähigkeitstyp wie die Schicht 36, so besitzt
die Schicht 361 den entgegengesetzten Leitfähigkeitstyp.

...

Das Halbleiter-Bauelement gemäß FIG. 6 ist, entsprechend FIG. 4, auch derart änderbar, daß das ausgesandte Licht eine kleinere Wellenlänge hat als das empfangene. Dazu wird, entsprechend FIG. 5, der Lichtweg 4 an der Seite des Substrates 31 angebracht und die Schichten 31 bis 362 durchsichtig ausgebildet für die zu empfangende größere Wellenlänge. Mindestens eine der Schichten 361, 362 ist dann derart ausgelegt, daß mit der kleineren Wellenlänge ausgesandtes Licht in bzw. an diesen Schichten absorbiert bzw. reflektiert wird.

Der Erfindungsgedanke umfaßt eine Vielzahl von Ausführungsbeispielen, von denen lediglich die folgenden beschrieben werden:

In einem nicht dargestellen Ausführungsbeispiel sind auf einem elektrisch isolierenden, eventuell wärmeleitenden Trägermaterial, beispielsweise ein Keramikplättchen, ein- oder beidseitig mehrere erfindungsgemäße Halbleiter-Bauelemente aufgebracht, die gegebenenfalls auf unterschiedliche Licht-Wellenlängen abgestimmt sind. Mit derartigen Bauelementen sind beispielsweise Zwischenverstärker oder elektro-optische Umsetzer für Lichtleitfaserübertragungsstrecken herstellbar.

In einem weiteren nicht dargestellten Ausführungsbeispiel ist in einem Halbleiter-Bauelement eine derartige Halbleiter-Schichtenfolge, mit den zugehörigen Kontakten, ausgebildet, daß mehrere abhängige oder unabhängige elektro-optische Sender und/oder opto-elektrische Empfänger entstehen, die jeweils auf verschiedene Licht-Wellenlängen abgestimmt sind. Mit derartigen Bauelementen ist es beispielsweise möglich, mehrere Informationskanäle (jeweils Duplex-Betrieb) gleichzeitig über einen Lichtweg, z.B. Lichtleitfaser, zu übertragen. Ein dazu alternatives Ausführungsbeispiel ist in FIG. 7

...

schematisch dargestellt.

Auf einem Trägermaterial sind einzeln und/oder in integrierter Bauweise mehrere erfindungsgemäße Halbleiter-Bauelemente
20, erste Lichtwege 71 sowie mindestens ein optischer Verteiler 73 angebracht, der über mindestens eine optische Koppelstelle 74 mit mindestens einem Lichtweg 4 verbunden ist.

0053742

Licentia Patent-Verwaltungs-GmbH
Theodor-Stern-Kai 1

D-6000 Frankfurt (Main) 70

NE2-UL/Ja/rß
UL 80/102

Patentansprüche

1. Signalübertragungsverfahren mit mindestens einem Lichtweg, mindestens einem elektro-optischen Sender und mindestens einem opto-elektrischen Empfänger, dadurch gekennzeichnet, daß mindestens ein Halbleiter-Bauelement (20) verwendet wird, das mindestens einen elektro-optischen Sender (21) und mindestens einen opto-elektrischen Empfänger (22) enthält, wobei von dem Halbleiter-Bauelement (20) ausgesandtes und/oder empfangenes Licht unterschiedliche Wellenlängen besitzt.

2. Signalübertragungsverfahren nach Anspruch 1, dadurch gekennzeichnet, daß mindestens ein Lichtweg (4) unmittelbar an das Halbleiter-Bauelement (20) angekoppelt wird.

3. Signalübertragungsverfahren nach einem der vorhergehenden Ansprüche, dadurch gekennzeichnet, daß von mindestens einem Halbleiter-Bauelement (20) Licht ausgesandt und/oder empfangen wird, wobei das empfangene Licht durch mindestens eine Lichtwellenlänge gekennzeichnet wird, die in dem ausgesandten Licht fehlt.

...

4. Signalübertragungsverfahren nach einem der vorhergehenden Ansprüche, dadurch gekennzeichnet, daß von mindestens einem Halbleiter-Bauelement (20) im wesentlichen monochromatisches Licht ausgesandt und/oder empfangen wird, wobei das ausgesandte und das empfangene Licht unterschiedliche Lichtwellenlängen besitzen.

5. Signalübertragungsverfahren nach einem der vorhergehenden Ansprüche, dadurch gekennzeichnet, daß mindestens ein Halbleiter-Bauelement (20) verwendet wird, das aus einem Sender (21) und einem Empfänger (22) besteht, und daß an ein derartiges Halbleiter-Bauelement (20) lediglich ein Lichtweg (4) angekoppelt wird.

6. Signalübertragungsverfahren nach Anspruch 5, dadurch gekennzeichnet, daß mindestens zwei Halbleiter-Bauelemente (20) auf einem gemeinsamen Träger (70) angeordnet werden, und daß die Halbleiter-Bauelemente (20) an mindestens einen Lichtweg (4) angekoppelt werden.

7. Signalübertragungsverfahren nach Anspruch 6, dadurch gekennzeichnet, daß jeweils ein Halbleiter-Bauelement (20) an jeweils einen ersten Lichtweg (71) angekoppelt wird, und daß mindestens zwei erste Lichtwege (71) mittels eines optischen Verteilers (73) an einen zweiten Lichtweg (4) angekoppelt werden.

8. Halbleiter-Bauelement, insbesondere zur Durchführung des Signalübertragungsverfahrens nach einem der vorhergehenden Ansprüche, dadurch gekennzeichnet, daß auf einem Substratmaterial mindestens ein elektro-optischer Sender (21) und mindestens ein opto-elektrischer Empfänger (22) angeordnet sind, wobei der Empfänger (22) unempfindlich ist gegenüber

...

dem Licht, das von dem Sender (21) ausgesandt wird.

9. Halbleiter-Bauelement nach Anspruch 8, dadurch gekennzeichnet, daß Sender (21) und Empfänger (22) über eine gemeinsame Koppelstelle (23) an einem Lichtweg (4) ankoppelbar sind.

10. Halbleiter-Bauelement nach Anspruch 8 oder Anspruch 9, dadurch gekennzeichnet, daß der Sender (21) bzw. der Empfänger (22) jeweils Licht aussenden bzw. empfangen, das jeweils im wesentlichen durch eine Lichtwellenlänge gekennzeichnet ist, wobei ausgesandtes bzw. empfangenes Licht im wesentlichen keine gemeinsame Lichtwellenlänge besitzen.

11. Halbleiter-Bauelement nach einem der Ansprüche 8 bis 10, dadurch gekennzeichnet, daß eine aus Halbleitermaterial bestehende, übereinanderliegende Schichtenfolge vorhanden ist, die den Sender (21) und den Empfänger (22) enthält, und daß mindestens ein Lichtweg (4) im wesentlichen senkrecht zur Schichtenfolge an das Halbleiter-Bauelement (20) ankoppelbar ist.

12. Halbleiter-Bauelement nach Anspruch 11, dadurch gekennzeichnet, daß durch die Schichtenfolge pn-Übergänge entstehen, derart, daß mindestens eine als Sender (21) wirkende lichtemittierende Diode und mindestens ein als Empfänger (22) wirkender Photodetektor vorhanden sind.

13. Halbleiter-Bauelement nach Anspruch 11 oder Anspruch 12, dadurch gekennzeichnet, daß die Schichtenfolge derart ausgebildet ist, daß Sender (21) bzw. Empfänger (22) für Lichtemission bzw. Lichtabsorption unterschiedliche Bandabstände

...

besitzen, wobei das der Koppelstelle (23) nächstgelegene Element (Sender oder Empfänger) den höheren Bandabstand aufweist.

14. Halbleiter-Bauelement nach einem der Ansprüche 8 bis 13, dadurch gekennzeichnet, daß auf einem Substratmaterial beidseitig Halbleiterschichten derart aufgebracht sind, daß auf einer Seite des Substratmaterials Sender angeordnet sind während auf der anderen Seite Empfänger vorhanden sind.

15. Halbleiter-Bauelement nach einem der Ansprüche 8 bis 14, dadurch gekennzeichnet, daß mindestens ein Sender (21) und/ oder mindestens ein Empfänger (22) eine Heterostruktur ihrer Schichtenfolgen besitzen.

16. Halbleiter-Bauelement nach einem der Ansprüche 8 bis 15 gekennzeichnet durch Halbleiterschichten (31, 32, 34, 35, 36, 39, 40) mit folgenden Merkmalen:
In der Schicht (32) sind Mittel vorgesehen, daß ein Strompfad (33) einheitlichen Leitfähigkeitstyps vom Substrat bzw. der Schicht (31) bis zu Schicht (34) entsteht;
Der Leitfähigkeitstyp der Schichten (35, 36) ist entgegengesetzt dem Leitfähigkeitstyp des Substrates bzw. der Schicht (31);
Der Leitfähigkeitstyp der Schicht (40) ist entgegengesetzt dem Leitfähigkeitstyp der Schicht (35) bzw. der Schicht (36);
An den Schichten (31, 36, 40) sind Kontakte (37, 38, 40) vorgesehen.

17. Halbleiter-Bauelement nach Anspruch 16, dadurch gekennzeichnet, daß in einer Schicht (34) der Bandabstand kleiner ist als der Bandabstand in den angrenzenden Schichten (35, 36,

...

39, 40) und daß Mittel vorgesehen sind, an die äußere
Schicht (40) einen Lichtweg (4) anzukoppeln.

18. Halbleiter-Bauelement nach Anspruch 16, dadurch gekennzeichnet, daß in einer Schicht (39) der Bandabstand kleiner
ist als der Bandabstand der angrenzenden Schichten (36, 35,
34, 32, 31), daß in den Schichten (31, 32), der Bandabstand
größer ist als der Bandabstand in der Schicht (34), daß in
der Schicht (36) der Bandabstand kleiner ist als der Bandabstand in der Schicht (34), und daß Mittel vorgesehen sind,
an eine äußere Schicht (31) einen Lichtweg (4) anzukoppeln.

19. Halbleiter-Bauelement nach einem der Ansprüche 16 bis 18,
dadurch gekennzeichnet, daß die Schicht (31) und die Schicht
(40) p-dotiert sind und die übrigen Schichten (32, 35, 36)
n-dotiert sind.

20. Halbleiter-Bauelement nach einem der Ansprüche 8 bis 15,
gekennzeichnet durch Halbleiterschichten (31, 32, 34, 36,
361, 362, 39, 40) mit folgenden Merkmalen:
In der Schicht (32) sind Mittel vorgesehen, daß ein Strompfad
(33) einheitlichen Leitfähigkeitstyps vom Substrat bzw. der
Schichte (31) bis zur Schicht (34) entsteht; der Leitfähigkeitstyp der Schicht (36) ist entgegengesetzt dem Leitfähigkeitstyp
der Schicht (31) bzw. des Substrates;
mindestens eine Schicht (361, 362) besitzt einen Leitfähigkeitstyp der verschieden ist von der Schicht (36);
der Leitfähigkeitstyp der Schicht (40) ist verschieden vom
Leitfähigkeitstyp der Schicht (362);
wenigstens an den Schichten (40, 362, 31) sind Kontakte (41,
381, 38) vorgesehen.

...

21. Halbleiter-Bauelement nach Anspruch 20, dadurch gekennzeichnet, daß in der Schicht (34) der Bandabstand kleiner ist als der Bandabstand in den Schichten (36, 361, 362, 39, 40) und daß Mittel vorgesehen sind, an Schicht (40) einen Lichtweg (4) anzukoppeln.

22. Halbleiter-Bauelement nach Anspruch 20, dadurch gekennzeichnet, daß in der Schicht (39) der Bandabstand kleiner ist als der Bandabstand der angrenzenden Schichten (362, 361, 36, 34, 32, 31), daß der Bandabstand in den Schichten (32, 31) größer ist als der Bandabstand in der Schicht (34) und daß Mittel vorgesehen sind, an Schicht (31) einen Lichtweg (4) anzukoppeln.

23. Elektro-optisches Bauelement, insbesondere zur Durchführung des Signalübertragungsverfahrens nach Anspruch 1  , dadurch gekennzeichnet, daß auf einem Träger (70) mindestens zwei Halbleiter-Bauelemente (20) angeordnet sind, die über erste Lichtwege (71) mit mindestens einem optischen Verteiler (73) verbunden sind, an dessen mindestens eine Koppelstelle (74) mindestens ein Lichtweg (4) ankoppelbar ist.

24. Elektro-optisches Bauelement nach Anspruch 23, dadurch gekennzeichnet, daß das Bauelement als integriertes Bauelement ausgeführt ist.

0053742

1/1

FIG.1

FIG.2

FIG.3

FIG.4

FIG.5

FIG.6

FIG.7

0053742

**EUROPÄISCHER RECHERCHENBERICHT**

Europäisches
Patentamt

Nummer der Anmeldung

EP 81 10 9732

| Kategorie | Kennzeichnung des Dokuments mit Angabe, soweit erforderlich, der maßgeblichen Teile | betrifft Anspruch |
|---|---|---|
| X | FR - A - 2 273 371 (THOMSON-CSF) <br> * Seiten 1-4; Abbildungen 1-4 * <br> & DE - A - 2 523 681 <br> -- | 1,2,4, 5,8,9, 11-13, 15 |
| X | US - A - 4 176 367 (TOKYO SHIBAURA) <br> * Spalten 1-3; Abbildungen 1,2 * <br> -- | 1,2,4, 5,8,9, 11-13, 15,16, 20 |
| X | DE - A - 2 924 581 (WESTERN ELECTRIC) <br> * Seiten 20-31; Abbildungen 4-6 * <br> -- | 1-3,8- 11,13 |
| X | US - A - 4 179 702 (RESEARCH TRIANGLE INSTITUTE) <br> * Spalte 7, Zeile 55 - Spalte 9, Zeile 35; Abbildung 5 * <br> -- | 1,3,4, 10,12, 13,15 |
| A | EP - A - 0 001 952 (THOMSON-CSF) <br> ---- | |

**EINSCHLÄGIGE DOKUMENTE**

**KLASSIFIKATION DER ANMELDUNG (Int. Cl.³)**

H 01 L 31/12
H 04 B 9/00

**RECHERCHIERTE SACHGEBIETE (Int. Cl.³)**

H 01 L
H 04 B

**KATEGORIE DER GENANNTEN DOKUMENTE**

X: von besonderer Bedeutung allein betrachtet
Y: von besonderer Bedeutung in Verbindung mit einer anderen Veröffentlichung derselben Kategorie
A: technologischer Hintergrund
O: nichtschriftliche Offenbarung
P: Zwischenliteratur
T: der Erfindung zugrunde liegende Theorien oder Grundsätze
E: älteres Patentdokument, das jedoch erst am oder nach dem Anmeldedatum veröffentlicht worden ist
D: in der Anmeldung angeführtes Dokument
L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 09-03-1982 | ROUBERT |

EPA form 1503.1  06.78